# EUROPEAN PATENT SPECIFICATION

(11) **EP 3 925 070 B1**
(45) Date of publication and mention of the grant of the patent: **07.10.2026**
(21) Application number: 20754140.0
(22) Date of filing: 11.02.2020
(51) Int. Cl.: H10F 77/70, G02B 5/02, H02S 40/22, H10F 19/80, B82Y 40/00, B82Y 20/00, G02B 5/18

(54) **A CORRUGATED TRANSPARENT TOP PANEL FOR EITHER INCREASING OR DECREASING HARVESTING OF SOLAR RADIATION AND METHODS THEREOF**
GEWELLTE TRANSPARENTE DECKPLATTE ZUR ERHÖHUNG ODER VERMINDERUNG DER NUTZUNG VON SONNENSTRAHLUNG UND VERFAHREN DAFÜR
PANNEAU SUPÉRIEUR TRANSPARENT ONDULÉ POUR AUGMENTER OU DIMINUER LA COLLECTE DE RAYONNEMENT SOLAIRE ET PROCÉDÉS ASSOCIÉS

(30) Priority: 11.02.2019 IL 26478219
(43) Date of publication of application: 22.12.2021
(73) Proprietor: Shkalim, Reuven, Holon (IL); Levi Tsedek, Paz, Holon (IL); Levi, Rafi, Nethanya (IL)
(72) Inventor: Shkalim, Reuven, Holon (IL); Levi Tsedek, Paz, Holon (IL); Levi, Rafi, Nethanya (IL)
(74) Representative: Schlich
(86) International application number: PCT/IL2020/050161
(87) International publication number: WO 2020/165898

(56) References cited:
- EP-A1- 2 687 877
- WO-A1-2012/169602
- WO-A2-2011/098212
- KR-A- 20130 091 517
- US-A1- 2008 196 761
- US-A1- 2010 252 107
- US-A1- 2017 148 931

## Description

### Field of the invention

The present invention generally pertains to a corrugated transparent top panel provided useful for increasing or decreasing harvesting of solar radiation.

### Background of the invention

Coal combustion for electrical generation not only contributes to high levels of carbon dioxide emissions with the concomitant climate disruption, but also to conventional air pollution Coal fired electrical power plants released 23% of air pollutants and the largest contributors to U.S. carbon dioxide emission is electrical generation (31%). While coal use is declining due to natural gas resources and renewable energy growth, coal combustion still accounts for roughly 30-40% of U.S. carbon dioxide pollution, contributing to ever-expanding climate change. Air pollutants are classified into four groups: gaseous, persistent organic, heavy metals, and particulate matter.

The literature shows a positive correlation between mortality and morbidity due to outdoor air pollution. Specifically, it is well established in the historical and current literature that coal combustion results in emissions of carbon dioxide, methane (gaseous pollutants), particulate matter, nitrogen and sulfur oxides (gaseous), and mercury (heavy metal). Poor air quality from coal is well known to adversely affect human health including: mortality and morbidity effects on respiratory, cardiovascular, nervous, urinary, and digestive systems.

A full life cycle accounting of coal reveals an estimated $523.3 billion in damages (including social and environmental externalities), which is roughly $0.27/kWh generated. Thus, the externalities of coal-fired electricity are more than double the average cost of residential electricity in the U.S. of $0.12/kWh. Although coal is detrimental in all stages of its life cycle, combustion is the stage with the heaviest health burden in the form of mortality and morbidity effects due to outdoor air pollutants/emissions, see Prehoda, Emily W., and Joshua M. Pearce. "Potential lives saved by replacing coal with solar photovoltaic electricity production in the US." Renewable and Sustainable Energy Reviews 80 (2017): 710-715.

Compared to aforesaid conventional power generation sources, photovoltaic technology does not bring the serious environmental problems that these sources cause during generation, such as climate change, global warming, air pollution, acid rain and so on. Another advantage in relation to fossil fuels is that solar energy does not need to be extracted, refined or transported to the generation site, which is close to the load. However, during its life cycle, it consumes a large amount of energy and emits some greenhouse gases in some stages (manufacturing process of solar cells, assembly of photovoltaic modules and transport of material, among others).

Photovoltaic technologies, consume per unit of electricity produced, 64 times more material resources, 7 times more human resources and 10 times more capital than nuclear technology. Although this data is biased, this is a clear indication of the extreme inefficiency of PV technologies in regions of moderate sunshine to help achieve the goal of providing a resource-efficient, efficient electricity supply system. Due to the intermittent nature of electricity production in these regions, parallel electricity supply infrastructure needs to be provided, see Sampaio, Priscila Gonçalves Vasconcelos, and Mario Orestes Aguirre González. "Photovoltaic solar energy: Conceptual framework." Renewable and Sustainable Energy Reviews 74 (2017): 590-601.

Nevertheless, solar cells and photovoltaic cells characterized by various disadvantages, including limitations in the availability of systems on the market; high initial cost; need a relatively large area of installation; high dependence on technology development; and geographical conditions (solar irradiation).

EP 2 687 877 A1 discloses a transparent top panel according to the preamble of claim 1.

The scope of the present invention is to overcome at least a part of those drawbacks by introducing means and method for significantly decreasing efficiency thereby reducing required installation area and reducing dependency on solar & geographical conditions.

### Summary of the invention

The invention is directed to a transparent top panel useful for providing a favorable incident angle for solar light at the exterior surface of a photovoltaic or solar cell, according to claim 1, said transparent top panel comprising an exterior surface, having a layer configured for scattering and diffracting a solar light being incident thereto; wherein said layer comprises distance-d₁-spaced primary corrugations made of at least one first transparent composition; said primary corrugations further comprising distance-d₂-spaced secondary corrugations made of at least one second transparent composition by means of varying of a thickness or a refractive index thereof within said primary corrugations; said first distance d₁ being at least 5 times said second distance d₂; said secondary corrugations further comprising distance d₃-spaced tertiary corrugations made of at least one third transparent composition by means of varying of a thickness or a refractive index thereof within said secondary corrugations; said second distance d₂ being at least 5 times said third distance d₃;
wherein said primary corrugations form a regular, evenly-spaced pattern on said substrate, said secondary corrugations form a regular, evenly-spaced pattern on said primary corrugations and said tertiary corrugations form a regular, evenly-spaced pattern on said secondary corrugations;
further wherein a cross-section of said tertiary corrugations comprises a plurality of different slopes.

Further developments are according to dependent claims 2-8.

### Brief description of the figures

The accompanying drawings, which are incorporated in and constitute a part of this specification, illustrate aspects of the present teachings and together with the description, serve to explain principles of the present teachings. In the figures:
**Fig. 1** illustrates schematically and in an out-of-scale manner an upper surface of either a photovoltaic cell or solar cell (**1**) according to one embodiment of the invention;
**Fig. 2** schematically and in an out-of-scale manner illustrates in a non-limiting manner several embodiments of corrugated transparent panel (**100**) according to another embodiment of the invention;
**Fig. 3** schematically and in an out-of-scale manner illustrates in a non-limiting manner embodiment of secondary and tertiary corrugated transparent panels (**100**) according to other embodiments of the invention;
**Fig. 4** schematically and in an out-of-scale manner illustrates in a non-limiting manner several embodiments of the macro, micro or nano structures according to another embodiment of the invention;
**Fig. 5** schematically and in an out-of-scale manner illustrates in a non-limiting manner several embodiments of the macro-, micro- or nano-structures according to another embodiment of the invention;
**Figs. 6** and **7** disclose a half-bubble-like microsphere (**124**) and light projecting/intensifying glass-like lens-like macro-structure (**125**) according to yet other examples not belong to the invention; and
**Figs. 8** and **9** disclose a solar/photovoltaic cell with panel (**126**) and greenhouse with panel (**127**) according to yet other embodiments of the invention.

### Detailed description of the preferred embodiments

Reference will now be made in detail to implementations of the present teachings, an example of which is illustrated in the accompanying drawings. Wherever possible, the same reference numbers will be used throughout the drawings to refer to the same or like parts.

In the following description, reference is made to the accompanying drawings that form a part thereof, and in which is shown by way of illustration specific implementations in which may be practiced. These implementations are described in sufficient detail to enable those skilled in the art to practice these implementations and it is to be understood that other implementations may be utilized and that changes may be made without departing from the scope of the present teachings. The following description is, therefore, merely exemplary.

The present invention generally pertains to a corrugated transparent top panel provided useful for either increasing or decreasing harvesting of solar radiation and to methods thereof. A special use of this panel is in photovoltaic cells, solar cells, windows, walls and agricultural structures.

The technology of the present invention is provided useful in various industries and utilizations, including, *inter alia*, coatings, film, patch, window shade that are widely used in all forms of human endeavor. Examples include commercial, industrial, medical, personal, residential and social. Industrial coatings, treatments and paint are used in many applications such as building interiors/exteriors, computers, consumer electronic devices, cosmetics, electrical, fabrics, furniture, home appliances, infrastructure, internal and/or external structural surfaces, luxury goods, telecommunications, mechanical and industrial equipment, media, medical devices and medical supplies. In addition to aesthetics of appearance, color, decoration, design and finish coatings are used for protection e.g. impermeability, hydrophobicity, shielding and resistance to electromagnetic, radio frequency, ultraviolet or other radiation. The acquisition of raw materials, manufacture production, transportation and application of such coatings consumes enormous amounts of energy and produces even greater volumes of greenhouse gasses, toxic waste products and other harmful emissions. Conventional coatings contain a high proportion of toxic materials and petrochemical products or derivatives. In the last half-century titanium and other metal oxides have been identified as possessing particular light scattering/absorbing properties. Such materials have been incorporated into many of these coatings.

This technology is provided for use in a variety of sectors and structural forms e.g. automotive, aviation, construction, engineering, transportation, etc. will realize substantial economic and ecological benefits. The invention described herein provides a method to influence temperature-dependent heat transport by modifying spectral emissivity and other features. The method concerns the engineering of active/passive wavelength and temperature dependent tunable coatings.

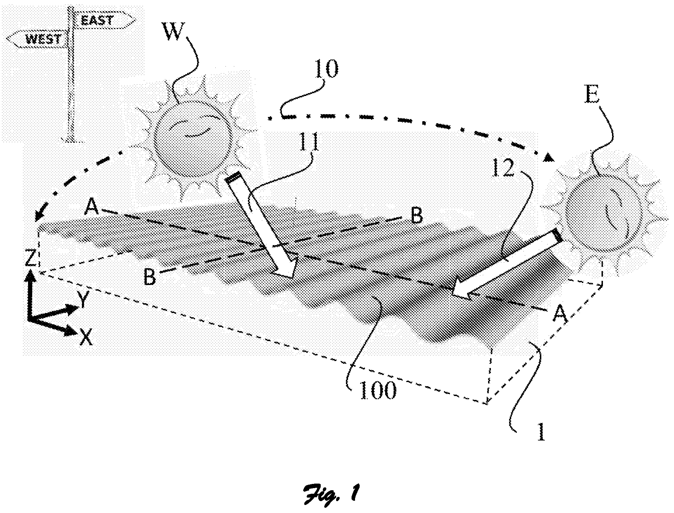

**Figure 1** illustrates schematically and in an out-of-scale manner an upper surface of either a photovoltaic cell or solar cell (**1**), optionally tilted southwards. In this embodiment, at least corrugated transparent panel (**100**), made of e.g., glass or polymers (PMMA, poly carbonate etc.) provides as the top of cell (**1**). Its curves are configured to maximize absorption of solar irradiation. Hence, in early mornings, when sun rises (**E**), eastern slopes faces light (**12**); whilst at sunset, light (**11**) from western sun (**W**) faces western slopes. Midday, when sun set (**10**) up above, concaved/convex panel maximize harvesting of solar energy.

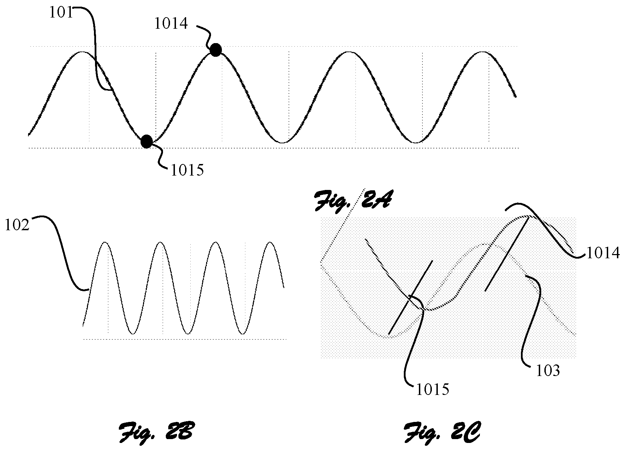

Reference is now made to **Fig. 2A-C,** schematically and in an out-of-scale manner illustrating in a non-limiting manner several embodiments of corrugated transparent panel (**100**). As schematically illustrated in **Fig. 2A****,** the sinusoidal or otherwise evenly or non-evenly waved surface of cross section **101** comprises a lower portion (**1015**) and a higher portion (**1014**). This waved, oscillating or fluted-wave one or more portion of the panel is characterized by either stiff walls (cross section, **Fig. 2B****, 102**) or slim walls (perspective front view, **Fig. 2C****, 103**), where minimum lines and maximum lines are either perpendicular to the continuous sine wave (see **Fig. 2A****,** lines **1014** and **1015**) or at least partially tilted (e.g., linearly, curved or rounded) to its main perpendicular axis

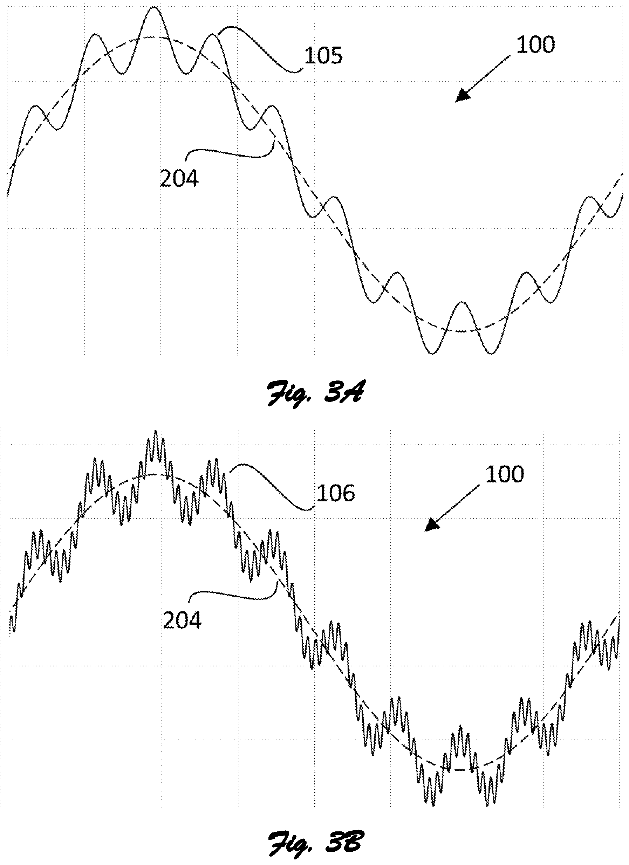

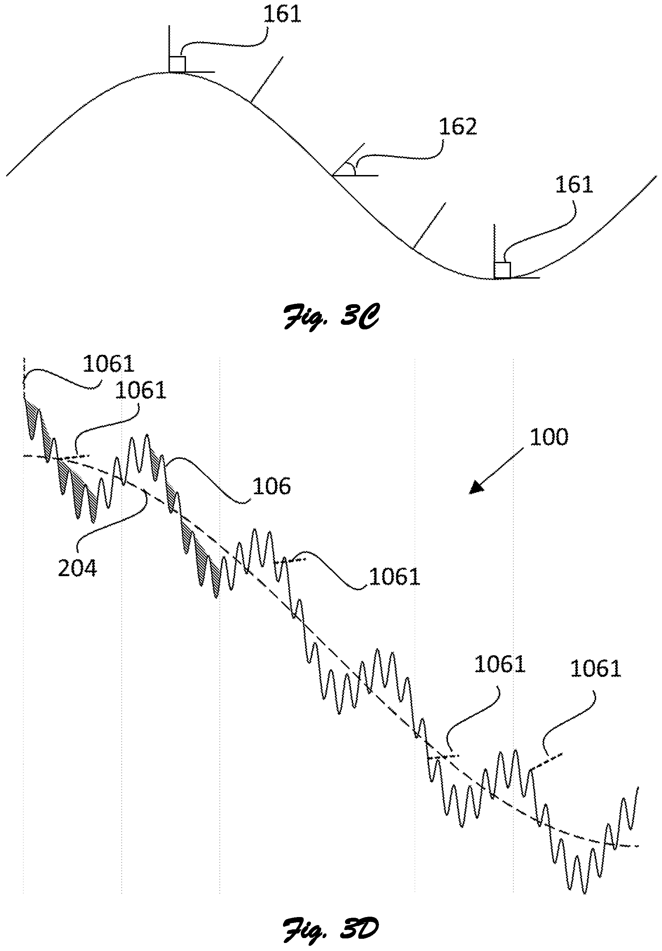

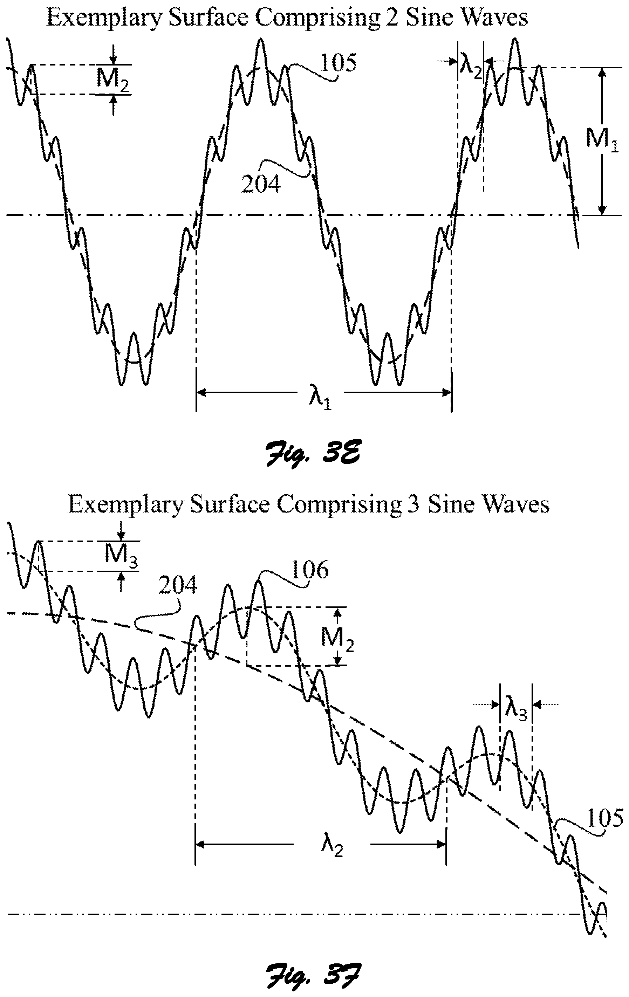

Reference is now made to **Fig. 3A-D,** where **Fig. 3C** schematically and in a non-limiting and out-of-scale manner illustrates a cross-section of a surface (**100**) of a transparent panel comprising a single sinusoid (**204**), **Fig. 3A** schematically and in a non-limiting and out-of-scale manner illustrates a cross-section of a surface (**100**) of a transparent panel with secondary sinusoidal corrugations (**105**) provided upon a primary sinusoidal wave (**204**), and **Figs. 3B** and **3D** schematically and in a non-limiting and out-of-scale manner illustrate a cross-section of a surface (**100**) of a transparent panel comprising secondary and tertiary sinusoidal corrugations (**106**) upon a primary sinusoidal wave (**204**).

If the surface is curved or otherwise comprises a plurality of angles relative to a plane comprising an average height of the surface, the angle between a perpendicular to the surface and the sun will be different on different positions on the surface. This is indicated schematically for a single sinusoid (**204**) in **Fig. 3C****.** For a single sinusoid (**204**), the sun's rays will be perpendicular to the surface at some time of the day if the angle between the sun and the horizon is between 45° (**162**) and 90° (**161**).

**Fig. 3D** schematically illustrates a portion of the surface (**100**) of **Fig. 3B****,** which comprises three sine waves of different wavelengths. The dashed line (**204**) indicates the longest-wavelength sine wave, while the solid line (**106**) shows the surface. Perpendiculars (**1061**) are shown at several points on the surface (**106**). It can be seen that the range of angles formed by the perpendicular to the surface is greater for a surface with secondary and tertiary corrugations (**106**) than for the single sinusoid (**204**) of **Fig. 3C****. Table** I shows the minimum angle formed by a perpendicular to a surface comprising either primary and secondary sinusoidal corrugations (third column), or primary, secondary and tertiary sinusoidal corrugations (fourth column). The maximum angle, in all cases, is 90°. In **Table I,** the frequency ratios vary while the magnitude ratios (M₁: M₂ and M₁:M₃) are kept constant.

**Table I**

| **Ratio of Waveleng ths λ₁: λ ₂** | **Ratio of Waveleng ths λ _{1:} λ ₃** | **Minimum Angle, Surface is Sum of Sinusoids with Frequencies f₁ and f₂ (°)** | **Minimum Angle, Surface is Sum of Sinusoids with Frequencies f₁, f₂ and f₃ (°)** |
|---|---|---|---|
| 5:1 | 25:1 | 26.5 | 12.5 |
| 6:1 | 30:1 | 24.8 | 11.0 |
| 6:1 | 36:1 | 24.8 | 9.9 |
| 10:1 | 50:1 | 18.5 | 5.4 |
| 10:1 | 80:1 | 18.5 | 11.6 |
| 10:1 | 100:1 | 18.5 | 4.4 |
| 10:1 | 160:1 | 18.5 | 3.1 |
| 11:1 | 101:1 | 17.6 | 4.4 |
| 11:1 | 110:1 | 17.6 | 4.1 |
| 12:1 | 110:1 | 16.4 | 4.0 |

From **Table I,** it can be seen that the third sinusoid significantly increases the range of angles over which the sun will be perpendicular to the surface, thereby increasing the portion of the day during which the sun is efficiently absorbed and decreasing the amount by which the surface needs to be rotated to follow the sun.
Tuning can also be done by varying the relative magnitudes of the secondary and tertiary corrugations relative to the primary corrugations. **Table II** shows some exemplary minimum angles for different relative magnitudes. All have the same relative wavelengths, λ₁: λ ₂ is 6:1 and λ ₁: λ ₃ is 30:1. In all cases, the maximum angle is 90°.

**Table II**

| **Ratio of Magnitu des M₁:M₂** | **Ratio of Magnitu des M₁:M₃** | **Minimum Angle, Surface is Sum of Sinusoids with Magnitudes M₁ and M₂** | **Minimum Angle, Surface is Sum of Sinusoids with Magnitudes M₁, M₂ and M₃ (°)** |
|---|---|---|---|
| 1:2 | 1:20 | 14.2 | 10.4 |
| 1:5 | 1:10 | 24.8 | 11 |
| 1:5 | 1:20 | 24.8 | 15.3 |
| 1:10 | 1:10 | 32.5 | 12.4 |
| 1:10 | 1:20 | 32.5 | 18.1 |
| 1:30 | 1:60 | 40.5 | 31.0 |

In addition, in at least some part of the surface, the tertiary corrugations are close-packed, allowing multiple reflections and further increasing possible absorption of sunlight. Some exemplary areas where multiple reflections are likely to occur for at least some sun angles are schematically illustrated in grey in **Fig. 3D****.** Other such areas, although not greyed, are clearly present. The amount of absorption by multiple reflection can be adjusted by adjusting the relative magnitudes of the secondary and tertiary corrugations relative to the primary corrugation and to each other. A smaller magnitude of the tertiary corrugations or a longer wavelength for the tertiary corrugations relative to the secondary corrugations will decrease the amount of absorption due to multiple reflection by decreasing the area where multiple reflections can occur.

For a structure such as that illustrated in **Fig. 3D****,** in which the left-facing sides and the right-facing sides defined by the primary corrugation are mirror images of each other, the fraction of sunlight absorbed at a given amount of time before local noon will be the same as the fraction of sunlight absorbed at the same amount of time after local noon.

Aforesaid primary, secondary, tertiary arrangements are merely an example for macro structures, e.g., scaled from 0.01 cm to 1 cm, from 1 cm to 100 cm, from 100 cm to 1500 cm; and/or micro-structures, e.g., scaled from 0.01 µm to 1 µm, from 1 µm to 100 µm, from 100 µm to 1,500 µm; or nano-structures, e.g., scaled from 1 nm to 100 nm, from 100 nm to 500 nm, from 500 nm to 1,000 nm. Aforesaid primary, secondary, tertiary arrangements are at least partially provided in a liquid phase, solid phase or any mixture thereof, flexible, semi-flexible or inflexible or rigid mode.

In preferred embodiments, the frequency of the secondary corrugations is at least five times the frequency of the primary corrugations, and the frequency of the tertiary corrugations is at least five times the frequency of the secondary corrugations, so that the frequency of the tertiary corrugations is at least 25 times the frequency of the primary corrugations. In other words, the wavelength of the secondary corrugations is no more than 1/5 the wavelength of the primary corrugations, and the wavelength of the tertiary corrugations is no more than 1/5 the wavelength of the secondary corrugations.

The secondary corrugations can be of the same material as the primary corrugations, with a varying refractive index across the surface generated by the varying thickness of the material caused by the primary and secondary corrugations, the secondary corrugations can be of a different material than the primary corrugations, with the two materials having a different refractive index and any combination thereof.

The tertiary corrugations can be of the same material as the secondary corrugations, with a varying refractive index across the surface generated by the varying thickness of the material caused by the secondary and tertiary corrugations, the tertiary corrugations can be of a different material than the secondary corrugations, with the two materials having a different refractive index and any combination thereof.

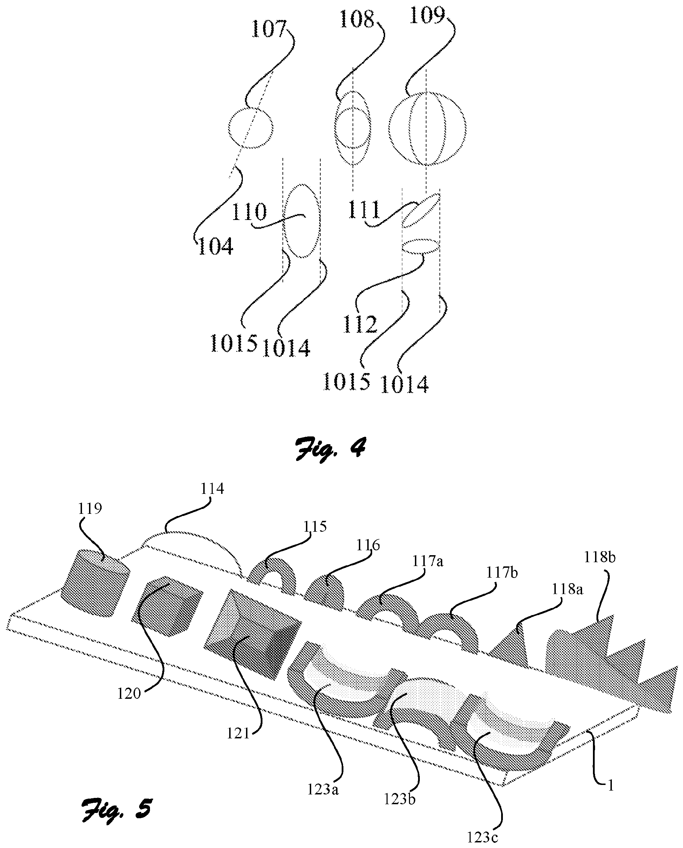

Reference is now made to **Fig. 4****,** schematically and in an out-of-scale manner illustrates in a non-limiting manner several embodiments of the macro, micro or nano structures wherein their top view is substantially rounded **107,** provided in top or bottom wave line (**104**) and/or anywhere in-between those lines, rounded top and ellipsoidal base **108,** rounded base and top **109,** ellipsoidal arrangement (**110**) having a main longitudinal axis being parallel to wave base **1015** and/or top **104b** lines; and ellipsoidal arrangement (**110**) having a main longitudinal axis being parallel to wave base **1015** line and/or top **1014** line, tertiary ellipsoidal arrangement and secondary arrangement (**111,112,** respectively) having a main longitudinal axis being tilted or perpendicular to either or both wave base **1015** and/or top **1014.**

Reference is now made to **Fig. 5****,** schematically and in an out-of-scale manner illustrates in a non-limiting manner several embodiments of the macro-, micro- or nano-structures, on either planar (**1**) or texturized (waved etc.) plane, wherein cross section of a concave shaped structure is at least partially, homogenously or heterogeneously having a very thin wall (nano-scale **114**), wider wall (micro-scale, **115**) or is filled member (**116**). The primary (**118a**), secondary (**118b**), tertiary arrangements structures can be rectangular, circular or otherwise shaped. Hence, as shown in a 3D perspective manner, substantially tubular structures (**119**), substantially cubic structures (**120**), substantially pyramidal structures (**121**) shapes or any mixture and combination thereof (e.g., concave **123a, c** and convex **123b** integrated or non-integrated multiple or singular structures, respectively, are provided useful.

The present device provides a corrugated surface where the corrugations are controllable, tunable and regular. The corrugations, including the tertiary corrugations, are preferably significantly longer than they are wide, unlike etched structures which are dependent on the crystallinity of the substrate so that etched structures on a crystalline material are typically approximately equi-axed. Furthermore, etching of an amorphous material reduces the thickness of the amorphous layer approximately evenly; no semi-regular peaks which are usable for refracting sunlight are produced.

Corrugations that are at least partially curved in cross-section and are preferably significantly longer than they are wide will more efficiently capture sunlight than approximately equi-axed structures that have flat sides. For example, for pyramidal structures, if the structure is aligned so that east-facing sides of the pyramids face the morning sun and the west-facing sides of the pyramids face the afternoon sun, then, when the sunlight is perpendicular to the sun-facing surfaces for an angle in a horizontal plane, approximately half of the sunlight will miss the surfaces entirely, by passing between the adjacent pyramids. If the sunlight strikes the sunward-facing surfaces at a horizontally-oblique angle, some of the sunlight will strike the south-facing surfaces, but such sunlight will strike the south-facing surfaces at a glancing angle and thus will not be efficiently absorbed, since, if the sunlight strikes east-facing sides of pyramids at an oblique, horizontal, angle of θₕ, then it will strike south (or north) facing sides at an angle of (90-θₕ), for θₕ close to 90° for efficiency in capture for east (or west) facing slopes, (90-θₕ) will be close to 0 and capture will be inefficient.

In the device of the present invention, with corrugations significantly longer than they are wide, the gaps between capturing sections are relatively small to non-existent, so that most to all of the east-facing (or west-facing) slopes will capture sunlight, whatever the horizontal angle of the sunlight and the horizontally oblique angle at which the sunlight strikes the corrugations will be the same for most if not all of the corrugations.

In addition, the longer-wavelength corrugations are more efficient at trapping long wavelength light, whereas the shorter-wavelength corrugations are more efficient at trapping the short-wavelength light, thereby making absorption of light more efficient across the wavelength spectrum and ensuring more even absorption across a day, where the early morning, late evening light comprises more long-wavelength than the midday sun, which loses less short-wavelength light to atmospheric and dust absorption.

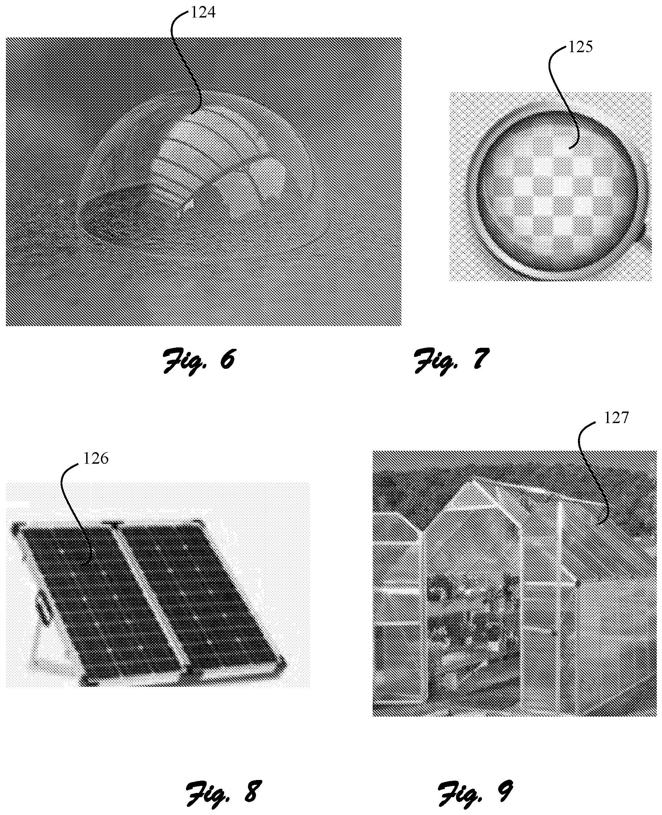

**Figures 6** and **7** discloses a half-bubble-like microsphere (**124**) and light projecting/intensifying glass-like lens-like macro-structure (**125**) according to yet other examples.

**Figures 8** and **9** discloses a solar/photovoltaic cell with panel (**126**) and greenhouse with panel (**127**) according to yet other embodiments of the invention.

## Claims

1. A transparent top panel (100) useful for providing a favorable incident angle for solar light (11, 12) at the exterior surface of a photovoltaic or solar cell (1), said transparent top panel comprising an exterior surface, having a layer configured for scattering and diffracting a solar light being incident thereto; wherein said layer comprises distance-d₁-spaced primary corrugations (204) made of at least one first transparent composition; said primary corrugations (204) further comprising distance-d₂-spaced secondary corrugations (105) made of at least one second transparent composition by means of varying of a thickness or a refractive index thereof within said primary corrugations; said first distance d₁ being at least 5 times said second distance d₂; **characterized in that**
said secondary corrugations (105) further comprise distance d₃-spaced tertiary corrugations (106) made of at least one third transparent composition by means of varying of a thickness or a refractive index thereof within said secondary corrugations (105); said second distance d₂ being at least 5 times said third distance d₃; and
**in that** said primary corrugations (204) form a regular, evenly-spaced pattern on said substrate, said secondary corrugations (105) form a regular, evenly-spaced pattern on said primary corrugations (204) and said tertiary corrugations (106) form a regular, evenly-spaced pattern on said secondary corrugations (105);
wherein a cross-section of said tertiary corrugations (106) comprises a plurality of different slopes.

2. The transparent top panel (100) of claim 1, wherein alternatively the following is true:
a a first shape of said primary corrugations (204) is selected from a group consisting of circular cross-section, ellipsoidal cross-section and lenticular; and
b a second shape of said primary corrugations (204) is selected from a group consisting of tubular, cubic, truncated rectangular pyramid, spherical, and ellipsoidal.

3. The transparent top panel (100) of claim 1, wherein alternatively the following is true:
a a first shape of said secondary corrugations (105) is selected from a group consisting of circular cross-section, ellipsoidal cross-section and lenticular; and
b a second shape of said secondary corrugations (105) is selected from a group consisting of tubular, cubic, truncated rectangular pyramid, spherical, and ellipsoidal.

4. The transparent top panel (100) of claim 1, wherein alternatively the following is true:
a a first shape of said tertiary corrugations (106) is selected from a group consisting of circular cross-section, ellipsoidal cross-section and lenticular; and
b a second shape of said tertiary corrugations (106) is selected from a group consisting of tubular, cubic, truncated rectangular pyramid, spherical, and ellipsoidal.

5. The transparent top panel (100) of claim 1, wherein at least one of the following is true: a cross-section of a member of a group consisting of said primary corrugations (204), said secondary corrugations (105) and any combination thereof comprises a plurality of different slopes; and
at least a portion of a cross-section of a member of a group consisting of said primary corrugations (204), said secondary corrugations (105), said tertiary corrugations (106) and any combination thereof is curved.

6. The panel (100) of claim 1, wherein a material of said panel is selected from a group consisting of a flexible material, a semi-flexible material an inflexible material and any combination thereof.

7. The panel (100) of claim 1, wherein said primary, secondary, and tertiary corrugations are made of a material selected from a group consisting of a polymer, a glass, a sol, a gel, a sol-gel, a composite material and any combination thereof.

8. The panel (100) of claim 1, wherein said panel comprises a first surface and a second opposite surface, said second surface being interconnected with or otherwise comprising a member of a group consisting of an adhesive, a glue and a fixating means.

## Patentansprüche

1. Transparente Deckplatte (100), die nützlich ist, um einen günstigen Einfallswinkel für Sonnenlicht (11, 12) an der Außenfläche einer Photovoltaik- oder Solarzelle (1) bereitzustellen, die transparente Deckplatte umfassend eine Außenfläche, die eine Schicht aufweist, die konfiguriert ist, um ein darauf einfallendes Sonnenlicht zu streuen und zu beugen; wobei die Schicht in einem Abstand d₁ beabstandete primäre Wellungen (204) umfasst, die aus mindestens einer ersten transparenten Zusammensetzung gefertigt sind; die primären Wellungen (204) ferner umfassend in einem Abstand d₂ beabstandete sekundäre Wellungen (105), die aus mindestens einer zweiten transparenten Zusammensetzung mittels Variieren einer Stärke oder eines Brechungsindex davon innerhalb der primären Wellungen gefertigt sind; wobei der erste Abstand d₁ mindestens das 5-fache des zweiten Abstands d₂ ist; **dadurch gekennzeichnet, dass** die sekundären Wellungen (105) ferner in einem Abstand d₃ beabstandete tertiäre Wellungen (106) umfassen, die aus mindestens einer dritten transparenten Zusammensetzung mittels Variieren einer Stärke oder eines Brechungsindex davon innerhalb der sekundären Wellungen (105) gefertigt sind; wobei der zweite Abstand d₂ mindestens das 5-fache des dritten Abstands d₃ ist;
und
dass die primären Wellungen (204) ein regelmäßiges, gleichförmig beabstandetes Muster auf dem Substrat bilden, die sekundären Wellungen (105) ein regelmäßiges, gleichförmig beabstandetes Muster auf den primären Wellungen (204) bilden und die tertiären Wellungen (106) ein regelmäßiges, gleichförmig beabstandetes Muster auf den sekundären Wellungen (105) bilden;
wobei ein Querschnitt der tertiären Wellungen (106) eine Vielzahl von unterschiedlichen Steigungen umfasst.

2. Transparente Deckplatte (100) nach Anspruch 1, wobei alternativ Folgendes gilt:
a eine erste Form der primären Wellungen (204) ist ausgewählt aus einer Gruppe, bestehend aus einem kreisförmigen Querschnitt, einem ellipsoiden Querschnitt und einem linsenförmigen Querschnitt; und
b eine zweite Form der primären Wellungen (204) ist ausgewählt aus einer Gruppe, bestehend aus rohrförmigen, kubischen, rechteckigen Pyramidenstümpfen, kugelförmigen und ellipsoiden Formen.

3. Transparente Deckplatte (100) nach Anspruch 1, wobei alternativ Folgendes gilt:
a eine erste Form der sekundären Wellungen (105) ist ausgewählt aus einer Gruppe, bestehend aus einem kreisförmigen Querschnitt, einem ellipsoiden Querschnitt und einem linsenförmigen Querschnitt; und
b eine zweite Form der sekundären Wellungen (105) ist ausgewählt aus einer Gruppe, bestehend aus rohrförmigen, kubischen, rechteckigen Pyramidenstümpfen, kugelförmigen und ellipsoiden Formen.

4. Transparente Deckplatte (100) nach Anspruch 1, wobei alternativ Folgendes gilt:
a eine erste Form der tertiären Wellungen (106) ist ausgewählt aus einer Gruppe, bestehend aus einem kreisförmigen Querschnitt, einem ellipsoiden Querschnitt und einem linsenförmigen Querschnitt; und
b eine zweite Form der tertiären Wellungen (106) ist ausgewählt aus einer Gruppe, bestehend aus rohrförmigen, kubischen, rechteckigen Pyramidenstümpfen, kugelförmigen und ellipsoiden Formen.

5. Transparente Deckplatte (100) nach Anspruch 1, wobei mindestens eines der Folgenden gilt: ein Querschnitt eines Elements einer Gruppe, die aus den primären Wellungen (204), den sekundären Wellungen (105) und einer beliebigen Kombination davon besteht, umfasst eine Vielzahl von unterschiedlichen Steigungen; und
mindestens ein Teil eines Querschnitts eines Elements einer Gruppe, die aus den primären Wellungen (204), den sekundären Wellungen (105), den tertiären Wellungen (106) und einer beliebigen Kombination davon besteht, ist gekrümmt.

6. Platte (100) nach Anspruch 1, wobei ein Material der Platte ausgewählt ist aus einer Gruppe, bestehend aus einem flexiblen Material, einem halbflexiblen Material, einem unflexiblen Material und einer beliebigen Kombination davon.

7. Platte (100) nach Anspruch 1, wobei die primären, sekundären und tertiären Wellungen aus einem Material gefertigt sind, das ausgewählt ist aus einer Gruppe, bestehend aus einem Polymer, einem Glas, einem Sol, einem Gel, einem Sol-Gel, einem Verbundmaterial und einer beliebigen Kombination davon.

8. Platte (100) nach Anspruch 1, wobei die Platte eine erste Oberfläche und eine zweite, gegenüberliegende Oberfläche umfasst, wobei die zweite Oberfläche mit einem Element aus der Gruppe, bestehend aus einem Klebstoff, einem Leim und einer Fixiereinrichtung verbunden ist oder dieses anderweitig umfasst.

## Revendications

1. Panneau supérieur transparent (100) utile pour fournir un angle d'incidence favorable pour de la lumière solaire (11, 12) au niveau de la surface extérieure d'une cellule photovoltaïque ou solaire (1), ledit panneau supérieur transparent comprenant une surface extérieure, présentant une couche conçue pour diffuser et diffracter une lumière solaire qui lui est incidente ; dans lequel ladite couche comprend des ondulations primaires (204) espacées par une distance d₁ faites d'au moins une première composition transparente ; lesdites ondulations primaires (204) comprenant en outre des ondulations secondaires (105) espacées par une distance d₂ faites d'au moins une deuxième composition transparente au moyen d'une variation d'une épaisseur ou d'un indice de réfraction de celle-ci au sein desdites ondulations primaires ; ladite première distance d₁ étant d'au moins 5 fois ladite deuxième distance d₂ ; **caractérisé en ce que**
lesdites ondulations secondaires (105) comprennent en outre des ondulations tertiaires (106) espacées par une distance d₃ faites d'au moins une troisième composition transparente au moyen d'une variation d'une épaisseur ou d'un indice de réfraction de celle-ci au sein desdites ondulations secondaires (105) ; ladite deuxième distance d₂ étant d'au moins 5 fois ladite troisième distance d₃ ;
et
**en ce que** lesdites ondulations primaires (204) forment un motif régulier et uniformément espacé sur ledit substrat, lesdites ondulations secondaires (105) forment un motif régulier et uniformément espacé sur lesdites ondulations primaires (204) et lesdites ondulations tertiaires (106) forment un motif régulier et uniformément espacé sur lesdites ondulations secondaires (105) ;
dans lequel une section transversale desdites ondulations tertiaires (106) comprend une pluralité de pentes différentes.

2. Panneau supérieur transparent (100) de la revendication 1, dans lequel, en variante, ce qui suit est vrai :
a une première forme desdites ondulations primaires (204) est choisie dans un groupe constitué par une section transversale circulaire, une section transversale ellipsoïdale et lenticulaire ; et
b une seconde forme desdites ondulations primaires (204) est choisie dans un groupe constitué par une forme tubulaire, cubique, de pyramide rectangulaire tronquée, sphérique et ellipsoïdale.

3. Panneau supérieur transparent (100) de la revendication 1, dans lequel, en variante, ce qui suit est vrai :
a une première forme desdites ondulations secondaires (105) est choisie dans un groupe constitué par une section transversale circulaire, une section transversale ellipsoïdale et lenticulaire ; et
b une seconde forme desdites ondulations secondaires (105) est choisie dans un groupe constitué par une forme tubulaire, cubique, de pyramide rectangulaire tronquée, sphérique et ellipsoïdale.

4. Panneau supérieur transparent (100) de la revendication 1, dans lequel, en variante, ce qui suit est vrai :
a une première forme desdites ondulations tertiaires (106) est choisie dans un groupe constitué par une section transversale circulaire, une section transversale ellipsoïdale et lenticulaire ; et
b une seconde forme desdites ondulations tertiaires (106) est choisie dans un groupe constitué par une forme tubulaire, cubique, de pyramide rectangulaire tronquée, sphérique et ellipsoïdale.

5. Panneau supérieur transparent (100) de la revendication 1, dans lequel au moins l'un des suivants est vrai : une section transversale d'un élément d'un groupe constitué par lesdites ondulations primaires (204), lesdites ondulations secondaires (105) et toute combinaison de celles-ci comprend une pluralité de pentes différentes ; et au moins une partie d'une section transversale d'un élément d'un groupe constitué par lesdites ondulations primaires (204), lesdites ondulations secondaires (105), lesdites ondulations tertiaires (106) et toute combinaison de celles-ci est incurvée.

6. Panneau (100) de la revendication 1, dans lequel un matériau dudit panneau est choisi dans un groupe constitué par un matériau flexible, un matériau semi-flexible, un matériau inflexible et toute combinaison de ceux-ci.

7. Panneau (100) de la revendication 1, dans lequel lesdites ondulations primaires, secondaires et tertiaires sont faites d'un matériau choisi dans un groupe constitué par un polymère, un verre, un sol, un gel, un sol-gel, un matériau composite et de toute combinaison de ceux-ci.

8. Panneau (100) de la revendication 1, dans lequel ledit panneau comprend une première surface et une seconde surface opposée, ladite seconde surface étant reliée avec, ou comprenant autrement, un élément d'un groupe constitué par un adhésif, une colle et un moyen de fixation.
